Europäisches Patentamt

European Patent Office

Office européen des brevets

(19)

(11) Veröffentlichungsnummer: **0 208 100**
**A2**

## (12) EUROPÄISCHE PATENTANMELDUNG

(21) Anmeldenummer: 86106968.0

(22) Anmeldetag: 22.05.86

(51) Int. Cl.⁴: **H01J 37/05 , G01R 31/28**

(30) Priorität: 31.05.85 DE 3519585

(43) Veröffentlichungstag der Anmeldung:
**14.01.87 Patentblatt 87/03**

(84) Benannte Vertragsstaaten:
**DE FR GB IT NL**

(71) Anmelder: **Siemens Aktiengesellschaft Berlin
und München**
**Wittelsbacherplatz 2**
**D-8000 München 2(DE)**

(72) Erfinder: **Plies, Erich, Dr.Dipl.-Phys.**
**Deisenhofener Strasse 79c**
**D-8000 München 90(DE)**
Erfinder: **Argyo, Wilhelm**
**Erikamerstrasse 8**
**D-8150 Holzkirchen(DE)**

(54) Elektrostatisches Gegenfeld-Spektrometer für die Elektronenstrahl-Messtechnik.

(57) Zur Verbesserung der Kennlinie eines elektrostatischen Gegenfeld-Spektrometers wird ein Ablenkelement eingesetzt, das erfindungsgemäß eine auf positivem Potential ($V_{DN}$) liegenden Netzelektrode (DN) aufweist, die zusammen mit einer symmetrisch dasu angeordneten, auf negativem Potential ($V_{DE}$) liegenden Ablenkelektrode (DE) und den zwischen beiden Elektroden angeordneten Gehäuseteilen (GH) die Mantelfläche eines konzentrisch zur optischen Achse angeordneten Hohlzylinders bildet.

FIG 4

EP 0 208 100 A2

## Elektrostatisches Gegenfeld-Spektrometer für die Elektronenstrahl-Meßtechnik.

Die Erfindung betrifft ein elektrostatisches Gegenfeld-Spektrometer nach dem Oberbegriff des Patentanspruchs 1.

Die Funktionsweise integrierter Schaltungen wird gewöhnlich mit rechnergesteuerten Testanordnungen automatisch kontrolliert. Die so durchgeführten Tests sind aber in den meisten Fällen unvollständig, da erkannte Fehler nur sehr schwer lokalisierbar sind. Deshalb müssen insbesondere während der Entwicklungsphase zusätzliche Messungen im Innern der integrierten Schaltungen durchgeführt werden. Für diese Zwecke besonders geeignet sind kontaktlos und zerstörungsfrei arbeitende Elektronenstrahl-Meßgeräte, die man zunehmend in allen Bereichen der Entwicklung und Fertigung von mikroelektronischen Bauelementen einsetzt.

Besonders aufschlußreichreiche Hinweise zur Lokalisierung von Fehlern in hochintegrierten Schaltungen erhält man durch quantitative Messungen des zeitlichen Potentialverlaufes an ausgewählten Knotenpunkten der zu untersuchenden Bauelemente. Hierbei wird beispielsweise der in der elektronenoptischen Säule eines modifizierten Raster-Elektronenmikroskopes erzeugte Primärelektronenstrahl auf einem Meßpunkt positioniert und die vom Potential des Bauelementes abhängige Verschiebung der Energieverteilung der am Meßpunkt ausgelösten Sekundärelektronen in einem Spektrometer bestimmt.

Ein elektrostatisches Gegenfeld-Spektrometer ist aus der Veröffentlichung H.P. Feuerbaum in "SEM/1979/I, SEM Inc., ANF O'Hare, IL 60666, S.285-296 bekannt. Oberhalb eines aus Absaug- und Gegenfeldelektrode bestehenden Spektrometerteils ist ein Ablenkelement angeordnet, in dem aufgrund seines unsymmetrischen Aufbaues die auf achsenfernen Bahnen in der Nähe der Gehäuseteile laufenden Sekundärelektroden nur - schwach abglenkt werden und nicht zu dem in einem Sekundärelektroneni-Detektor gemessenen Signal beitragen. Geringe Sekundärelektronen-Ströme führen zu einem schlechten Signal-Rauschverhältnis und begrenzen die Auflösung, mit der Potentiale gemessen werden können.

Der Erfindung liegt deshalb die Aufgabe zugrunde, ein elektrostatisches Gegenfeld-Spektrometer anzugeben, dessen Ablenkelement zur Verbesserung der Spektrometer-Kennlinie eine im Vergleich zu bekannten Anordnungen deutlich gesteigerte Akzeptanz aufweist.

Diese Aufgabe wird erfindungsgemäß durch ein elektrostatisches Gegenfeld-Spektrometer der eingangs genannten Art gelöst, welches die kennzeichnenden Merkmale des Patentanspruchs 1 aufweist.

Der mit dem erfindungsgemäßen Gegenfeld-Spektrometer erzielbare Vorteil liegt insbesondere darin, daß das Signal-Rauschverhältnis und damit die Auflösung bei quantitativen Potentialmessungen deutlich gesteigert werden kann.

Die Ansprüche 1 bis 10 sind auf bevorzugte Ausgestaltungen und Weiterbildungen der Erfindung gerichtet.

Das erfindungsgemäße Gegenfeld-Spektrometer wird nachfolgend anhand der Zeichnung erläutert. Dabei zeigen:

Fig.1 ein elektrostatisches Gegenfeld-Spektrometer nach dem zitierten Stand der Technik,

Fig.2 das Ablenkelement des Spektrometers nach Fig.1 im Schnitt senkrecht zur optischen Achse,

Fig.3 bis 9 Ausführungsbeispiele erfindungsgemäßer Gegenfeld-Spektrometer.

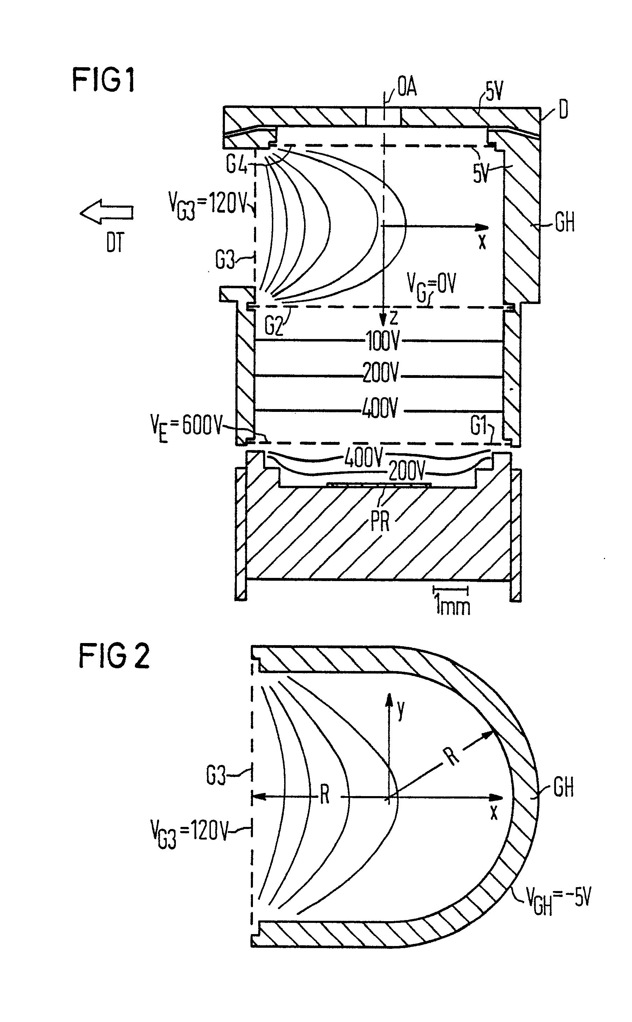

Zur quantitativen Potentialmessung an einer Probe, beispielsweise einem integrierten Schaltkreis, wird der in der elektronenoptischen Säule eines Elektronenstrahl-Meßgerätes erzeugte Primärelektronenstrahl auf dem zu untersuchenden Meßpunkt positioniert und die vom Potential des Meßpunktes abhängige Verschiebung der Energieverteilung der Sekundärelektronen mit einem Gegenfeld-Spektrometer bestimmt. Das in Fig.1 dargestellte elektrostatische Gegenfeld-Spektrometer ist dem Fachmann aus der genannten Veröffentlichung von Feuerbaum bekannt, so daß im folgenden nur kurz auf dessen Aufbau und Wirkungsweise eingegangen wird.

Zur Unterdrückung elektrostatischer Nahfelder an der Probenoberfläche wird mit Hilfe einer unmittelbar oberhalb der Probe PR angeordneten ebenen Absaugelektrode G1 ein starkes Absaugfeld von beispielsweise 6 kV/cm erzeugt. Die an der Meßstelle ausgelösten Sekundärelektronen werden dadurch zunächst in Richtung der Gitterelektrode G1 beschleunigt und gelangen dann zwischen den Elektroden G1 und G2 in ein abbremsendes Gegenfeld. Die Höhe des Potentialwalles ist über die Spannung $V_G$ der Gegenfeldelektrode G2 einstellbar und bestimmt den Bruchteil der Sekundärelektronen, die in das Ablenkelement gelangen. Die Höhe der Potentialbarriere wird so gewählt, daß nur die von lokalen elektrischen Feldern an der Probenoberfläche kaum beeinflußten höherenerge tischen Sekundärelektronen zum Meßsignal beitragen. Sekundärelektronen mit kinetischen Energien oberhalb dieser Potentialbarriere passieren die Gegenfeldelektrode G2 und gelangen in das Ablenkelement des Sekundärelektronen-Spektrometers, wo sie im Feld der auf einem Potential $V_{G3}$ von beispielsweise 120 Volt liegenden ebenen Gitterelektrode G3 abgelenkt und seitlich in Richtung des Pfeils zu einem -in Fig.1 nicht gezeigten -Detektor DT beschleunigt werden. Zur Verbesserung der Meßgenauigkeit ist unterhalb des Spektrometerdeckels D eine weitere ebene Gitterelektrode G4 angeordnet, mit der die im Bereich des Deckels D von schnellen Rückstreuelektronen ausgelösten Sekundärelektronen abgefangen werden.

Ein Schnitt durch das Ablenkteil des bekannten Spektrometers senkrecht zur optischen Achse ist in Fig.2 dargestellt. Aufgrund seines unsymmetrischen Aufbaues werden die auf achsenfernen Bahnen in der Nähe des Gehäuses GH laufenden Sekundärelektronen nur schwach abgelenkt und sind nicht im Detektor nachweisbar.

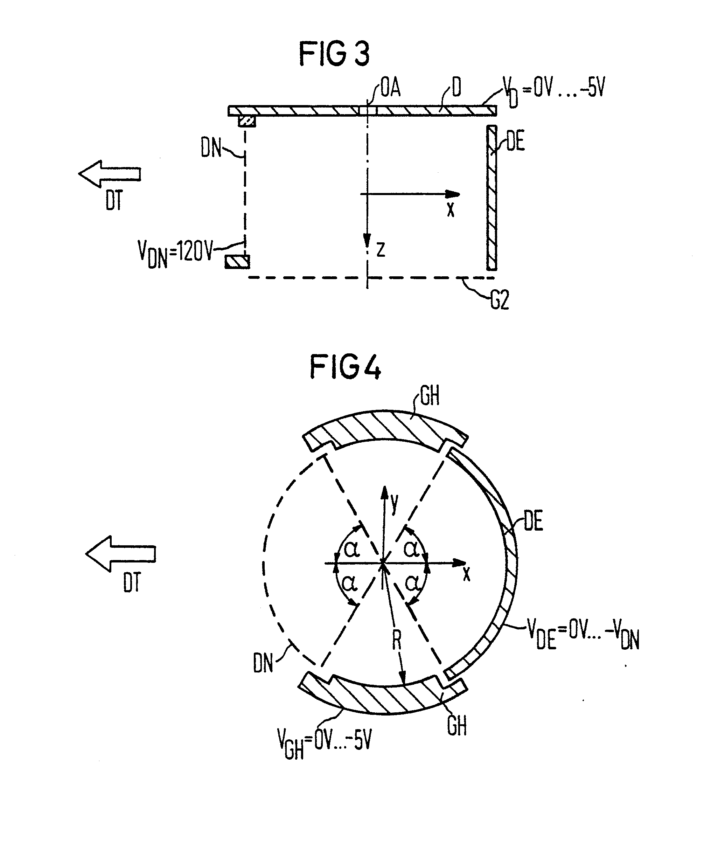

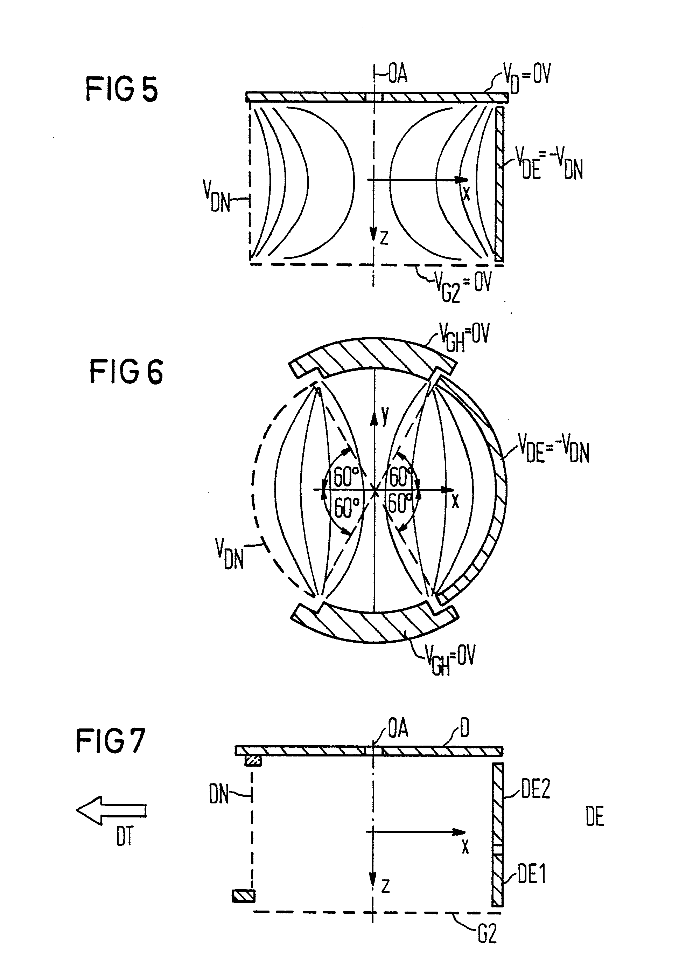

Um zu einem ersten Ausführungsbeispiel eines erfindungsgemäßen Gegenfeld-Spektrometers zu gelangen, wird das in den Fig.3 und 4 dargestellte Ablenkelement in ein Gegenfeld-Spektrometer nach Fig.1 eingebaut. Erfindungsgemäß weist dieses Ablenkelement eine auf positivem Potential $V_{DN}$ liegende Netzelektrode DN auf, die zusammen mit einer symmetrisch dazu angeordneten, auf negativem Potential $V_{DE}$ liegenden Ablenkelektrode DE und den zwischen diesen Elektroden angeordneten Gehäuseteilen GH die Mantelfläche eines konzentrisch zur Strahlachse liegenden Hohlzylinders bildet, so daß die Symmetrieachse des Ablenkelementes und die optische Achse OA zusammenfallen. Um möglichst alle der über die Gegenfeldelektrode G2 in das Ablenkelement gelangenden Sekundärelektronen in Richtung des Detektors abzulenken, sollte der Winkel $2\alpha$, unter dem Ablenkelektrode DE bzw. Netzelektrode DN als Teil der Mantelfläche eines Zylinders -von der optischen Achse OA aus betrachtet -jeweils erscheinen, vorteilhafterweise zwischen 100 und 140° betragen. In dem erfindungsgemäßen Gegenfeld-Spektrometer kann zusätzlich auch eine Gitterelektrode zum Abfangen der an dem Spektrometerdeckel D von Rückstreuelektronen ausgelösten Sekundärelektronen vorgesehen sein, die entsprechend dem Gitter G4 in Fig.1 unterhalb des Spektrometerdeckels D angeordnet wird.

Gegenüber der bekannten Anordnung nach Fig.2 zeichnet sich das erfindungsgemäße Ablenkelement u.a. durch eine verbesserte Absaugung der Sekundärelektronen aus, da die Netzelektrode DN als Teil einer Zylindermantelfläche näher an der optischen Achse OA liegt als die äußeren Teile des ebenen Ablenknetzes G3 aus Fig.2. Zusätzlich werden auch die in großem Abstand zur Netzelektrode DN auf achsenfernen Bahnen in der Nähe der Ablenkelektrode DE laufenden Sekundärelektroden im Feld dieser Elektrode seitlich in Richtung der Netzelektrode DN beschleunigt. Dies führt zu einer Steigerung des im Detektor gemessenen Sekundärelektronen-Stromes und damit unmittelbar zu einer Verbesserung der Spektrometer-Kennlinie. Eine optimale Spektrometer-Kennlinie wird durch eine geeignete Anpassung der Spannung $V_{DE}$ der Ablenkelektrode DE an die Spannung $V_{DN}$ der Netzelektrode DN erreicht. Vorteilhafterweise wird an die Ablenkelektrode DE bei vorgegebener positiver Netzelektroden-Spannung $V_{DN}$ eine Spannung $V_{DE}$ zwischen 0 Volt und $-V_{DN}$ angelegt. Besondere Vorteile ergeben sich, wenn Ablenkelektrode DE und Netzelektrode DN auf entgegengesetzt gleichem Potential ($V_{DE} = -V_{DN}$) liegen. In diesem Fall ist das elektrische Feld im Ablenkelement antisymmetrisch und der 2-zählige Quadrupol-Anteil des Feldes um die optische Achse OA verschwindet. Wählt man zusätzlich noch den Winkel $\alpha = 60°$, so verschwindet auch der 3-zählige Hexapol-Anteil des Feldes, wodurch ein 2-und 3-zähliger Astigmatismus des Primärelektronenstrahles weitgehend vermieden werden kann. Die sich unter diesen Bedingungen im Innern des erfindungsgemäßen Ablenkelementes aufbauende Potentialverteilung ist in den Fig.5 und 6 dargestellt.

Eine auf hohem negativen Potential $V_{DE}$ liegende Ablenkelektrode DE behindert den Durchtritt der auf achsenfernen Bahnen in der Nähe dieser Elektrode laufenden Sekundärelektronen durch die Gegenfeldelektrode G2. Die Transmission der Gegenfeldelektrode G2 im Bereich der Ablenkelektrode DE kann gesteigert werden, indem man die Ablenkelektrode DE nach dem in Fig.7 dargestellten Ausführungsbeispiel in einer Ebene senkrecht zur optischen Achse OA unterteilt. Der unmittelbar oberhalb der Gegenfeldelektrode G2 angeordnete Teil DE1 der Ablenkelektrode DE liegt hierbei auf einem dem Betrag nach kleineren Potential als der obere Teil DE2.

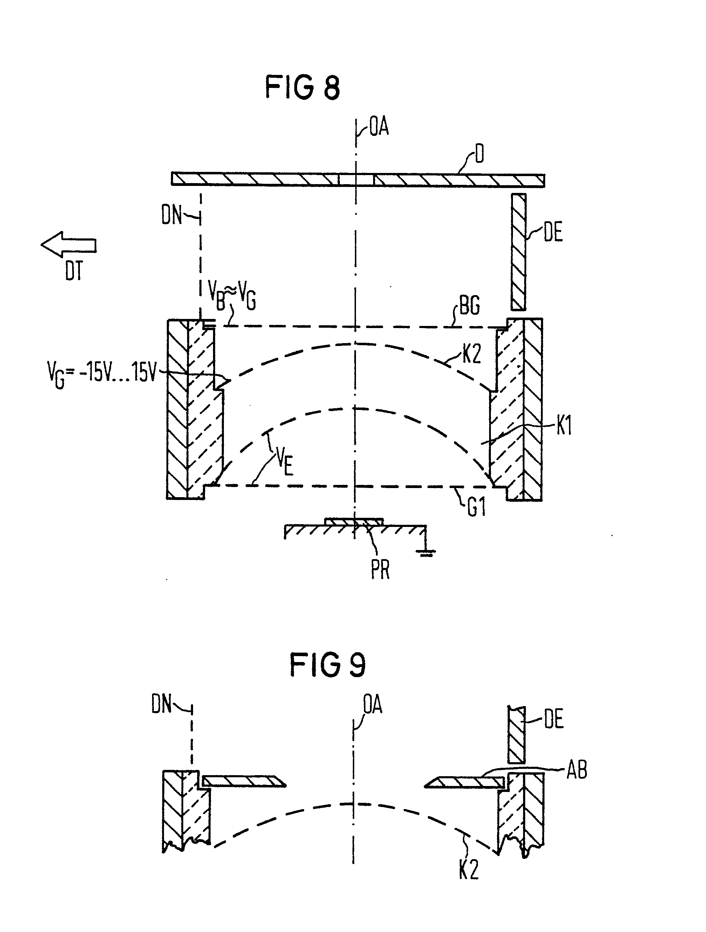

Das in Fig.8 dargestellte Ausführungsbeispiel eines erfindungsgemäßen Gegenfeld-Spektrometers besteht aus einem Ablenkelement nach Fig.3 bzw. 4 und einer aus der US-Patentschrift 4 464 571 bekannten Elektrodenanordnung zur Erzeugung eines die Sekundärelektronen isotrop abbremsenden kugelsymmetrischen Gegenfeldes. Während das kugelsymmetrische Netz K1 auf dem gleichen hohen positiven Potential $V_E$ wie das Absaugnetz G1 liegt, werden an das als Gegenfeldelektrode wirkende kugelsymmetrische Netz K2 üblicherweise Spannungen $V_G$ zwischen $+15$ und $-15$ Volt angelegt. Um Durchgriffe der an der Netzelektrode DN anliegenden positiven Spannung $V_{DN}$

in den Verzögerungsraum zwischen den kugelsymmetrischen Netzelektroden K1 und K2 zu vermeiden, ist zusätzlich zwischen dem oberen kugelsymmetrischen Netz K2 und dem Ablenkelement ein auf etwa gleichem Potential $V_G$ wie das kugelsymmetrische Netz K2 liegendes Abschirmgitter BG vorgesehen. Anstelle dieses Abschirmgitters BG kann auch eine in Fig.9 dargestellte Abschirmblende AB bzw. eine Blende mit darüberliegendem Netz vorgesehen werden.

## Ansprüche

1. Elektrostatisches Gegenfeld-Spektrometer zur quantitativen Potentialmessung,

-mit einer Elektrodenanordnung (G1) zum Absaugen der auf einer Probe (PR) ausgelösten Sekundärelektronen,

-einer Elektrodenanordnung (G2, K1, K2) zur Erzeugung eines die Sekundärelektronen abbremsenden Gegenfeldes

-und einer Anordnung zur Ablenkung und Beschleunigung der Sekundärelektronen in Richtung eines Detektors,

dadurch **gekennzeichnet** ,

daß die Anordnung zur Ablenkung und Beschleunigung der Sekundärelektronen (SE) in Richtung eines Detektors eine auf positivem Potential - ($V_{DN}$ ) liegende erste Ablenkelektrode (DN) und eine symmetrisch zu dieser ersten Ablenkelektrode angeordnete, auf negativem Potential ($V_{DE}$) liegende zweite Ablenkelektrode (DE) aufweist.

2. Elektrostatisches Gegenfeld-Spektrometer nach Anspruch 1, dadurch **gekennzeichnet** , daß die erste und zweite Ablenkelektrode (DE, DN) zusammen mit den zwischen diesen Ablenkelektroden angeordneten Gehäuseteilen (GH) des die Mantelfläche eines Hohlzylinders bilden, dessen Symmetrieachse mit der optischen Achse (OA) zusammenfällt.

3. Elektrostatisches Gegenfeld-Spektrometer nach Anspruch 1 oder 2, dadurch **gekennzeichnet** , daß der Winkel (2α), unter dem die erste bzw. die zweite Ablenkelektrode (DE, DN) als Teil der Mantelfläche eines konzentrisch zur optischen Achse - (OA) angeordneten Hohlzylinders von der optischen Achse (OA) aus betrachtet erscheinen, 100 bis 140° beträgt.

4. Elektrostatisches Gegenfeld-Spektrometer nach einem der Ansprüche 1 bis 3, dadurch **gekennzeichnet**, daß der Winkel (2α, unter dem die erste bzw. zweite Ablenkelektrode (DE, DN) als Teil der Mantelfläche eines konzentrisch zur optischen Achse angeordneten Hohlzlinders von der optischen Achse (OA) aus betrachtet erscheinen, 120° beträgt.

5. .Elektrostatisches Gegenfeld-Spektrometer nach einem der Ansprüche 1 bis 4, dadurch **gekennzeichnet** , daß die an der ersten und zweiten Ablenkelektrode (DE, DN) anliegenden Potentiale - ($V_{DE}$,$V_{DN}$) dem Betrag nach gleich groß sind, aber entgegengesetzte Vorzeichen aufweisen.

6.Elektrostatisches Gegenfeld-Spektrometer nach einem der Ansprüche 1 bis 5, dadurch **gekennzeichnet** , daß die auf negativem Potential - ($V_{DE}$) liegende zweite Ablenkelektrode (DE) in einer Ebene senkrecht zur optischen Achse (OA) unterteilt ist und daß der oberhalb der Gegenfeld-Elektrode (G2) angeordnete Teil (DE1) der zweiten Ablenkelektrode (DE) auf einem dem Betrag nach kleineren Potential liegt als der darüberliegende Teil (DE2) der Ablenkelektrode(DE).

7. Elektrostatisches Gengenfeld-Spektrometer nach einem der Ansprüche 1 bis 6, dadurch **gekennzeichnet** , daß zwischen der das Gegenfeld aufbauenden Elektrodenanordnung (G2, K1, K2) und dem Ablenkelement ein Abschirmgitter (BG) vorgesehen ist.

8. Elektrostatisches Gegenfeld-Spektrometer nach einem der Ansprüche 1 bis 7, dadurch **gekennzeichnet** , daß zwischen der das Gegenfeld aufbauenden Elektrodenanordnung (G2, K1 K2) und dem Ablenkelement eine Abschirmblende (AB) vorgesehen ist.

9. Elektrostatisches Gegenfeld-Spektrometer nach einem der Ansprüche 1 bis 8, **gekennzeichnet** durch eine ebene Gegenfeldelektrode (G2).

10. Elektrostatisches Gengenfeld-Spektrometer nach einem der Ansprüche 1 bis 8, **gekennzeichnet** durch zwei kugelsymmetrische Netzelektroden zur Erzeugung eines kugelsymmetrischen Gegenfeldes.

**FIG 1**

**FIG 2**

## FIG 3

$V_D = 0V \ldots -5V$

$V_{DN} = 120V$

OA  D  DN  DT  DE  G2  x  z

## FIG 4

GH  DE  DN  GH  DT  y  x  R  α  α  α  α

$V_{DE} = 0V \ldots -V_{DN}$

$V_{GH} = 0V \ldots -5V$

**FIG 5**

$V_D = 0V$

$-OA$

$V_{DE} = -V_{DN}$

$V_{DN}$

x

z

$V_{G2} = 0V$

**FIG 6**

$V_{GH} = 0V$

y

$V_{DE} = -V_{DN}$

60° 60°

60° 60°

x

$V_{DN}$

$V_{GH} = 0V$

**FIG 7**

OA    D

DT

DN

DE2

DE

x

z

DE1

G2

# FIG 8

# FIG 9